# EUROPÄISCHE PATENTSCHRIFT

(11) **EP 0 614 995 B1**
(45) Veröffentlichungstag und Bekanntmachung des Hinweises auf die Patenterteilung: **22.01.1997**
(21) Anmeldenummer: 93114254.1
(22) Anmeldetag: 06.09.1993
(51) Int. Cl.: C23C 14/04

(54) **Maske zum Abdecken des radial äusseren Bereichs einer scheibenförmigen Substratoberfläche**
Mask for shielding the periphery of a disc-shaped substrate surface
Masque pour protégér la périphérie d'une surface de substrat sous forme de disque

(30) Priorität: 09.03.1993 DE 4307382
(43) Veröffentlichungstag der Anmeldung: 14.09.1994
(73) Patentinhaber: Balzers und Leybold Deutschland Holding Aktiengesellschaft, 63450 Hanau (DE)
(72) Erfinder: Zejda, Jaroslav, D-63517 Rodenbach (DE)

(56) Entgegenhaltungen:
- DE-U- 9 206 635
- US-A- 4 561 954
- PATENT ABSTRACTS OF JAPAN vol. 13, no. 171 (C-588) 24. April 1989 & JP-A-64 003 035 (CENTRAL GLASS CO.) 6. Januar 1989

## Beschreibung

Die Erfindung betrifft eine Maske zum Abdecken einer Außenfläche des radial äußeren Bereichs einer Außenfläche eines scheibenförmigen Substrats während eines Beschichtungsverfahrens, beispielsweise einem Sputter- oder Aufdampfverfahren im Vakuum sowie Verfahren zum Abdecken.

Maschinenlesbare Datenspeicher für die vielseitigsten Anwendungen gewinnen zunehmend an Bedeutung. Je nach Einsatz und erforderlicher Speicherdichte unterscheidet man in magnetische, magneto-optische und optische Datenspeicher, wie z.B. Rigid-, Floppy-Disks, Magnetbänder und CD's. Allen Datenspeichern ist gemeinsam, daß im Mittelpunkt ihrer Herstellung ein Vakuumverfahren zur Aufbringung technischer Schichten steht.

In der vorliegenden Erfindung geht es im wesentlichen um die Herstellung magneto-optischer und optischer Datenspeicher. Als Grundkörper für diese Datenspeicher werden meist scheibenförmige Substrate aus Kunststoff, wie z.B. PC oder PMMA verwendet. Während der Aufbringung der Speicherschichten auf diese Substrate, werden Bereiche der Substratoberfläche abgedeckt. Zum Abdecken werden in aller Regel Masken verwendet, die den radial inneren und/oder den radial äußeren Bereich der Substratoberfläche abdecken. Diese Masken sind in der Beschichtungskammer stationär vor den jeweiligen Beschichtungsquellen angeordnet. Die zu beschichtenden Substrate werden durch ein Handling-System auf diese stationären Masken aufgelegt.

Die Durchmesser der scheibenförmigen Substrate sind standardisiert und liegen im wesentlichen zwischen 80 und 300 mm. Eine neue Generation von Datenspeichern ist gekennzeichnet durch Durchmesser, die kleiner als 80 mm sind. Durch diese Reduzierung des Durchmessers wird auch zwangläufig die zur Verfügung stehende Speicherfläche auf dem Substrat verkleinert. Die Hersteller solcher Datenspeicher sind nun bemüht, die nutzbare Speicherfläche optimal zu nutzen. Man ist daher bestrebt, die maskierten Flächen so klein als möglich zu gestalten und die Toleranzen, speziell der Außenmaske, zu minimieren.

Ein besonderes Problem stellen die Beschichtungsanlagen mit mehreren Stationen dar. Wenn die Substrate nacheinander in vielen Stationen beschichtet werden und der Anwender eine nur kleine Exzentrizität der Innen- und der Außenmaskierung erlaubt, dann ist es oft unmöglich, dies mit fest eingebauten, stationären Maskensystemen zu erreichen.

Aufgabe der vorliegenden Erfindung ist es nun, eine Maske anzugeben, die zum Abdecken des radial äußeren Bereichs scheibenförmiger Substrate während eines Beschichtungsverfahrens einsetzbar ist und die oben genannten Nachteile der fest eingebauten Maskensysteme vermeidet.

Diese Aufgabe wird erfindungsgemäß dadurch gelöst, daß die Maske aus einem elastischen Werkstoff hergestellt und als ebene Platte mit mindestens einer kreisförmigen Aussparung ausgebildet ist, wobei zur Zentrierung und Arretierung der Maske am Substrat das Substrat mit seiner radialen Umfangsfläche an der von der Aussparung gebildeten Wand der Maske direkt anliegt, wobei an diesem Wandteil eine konzentrische, sich radial nach innen zu in einer Ebene parallel zur Substratebene erstrekkende kreisförmige Fläche vorgesehen ist, auf die das Substrat mit seiner einen zu beschichtenden Seitenfläche auflegbar ist, wobei an dem von der Aussparung gebildeten Wandteil der Maske in einem konstanten Abstand zur Fläche sich radial nach innen zu erstreckende Zungen oder Noppen angeordnet sind, die an der anderen Seitenfläche des Substrats anliegen.

Mit Vorteil wird das Substrat in der erfindungsgemäßen Außenmaske zentriert, so daß sich Substrat und Maske nicht mehr gegeneinander verschieben. Bei den bislang gebräuchlichen stationären Masken betrug die minimal erreichbare Breite des Abdeckbereichs beispielsweise lmm, während mit der erfindungsgemäßen Maske, welche sich mit dem Substrat durch die Anlage bewegt, jetzt vorteilhafterweise eine minimale Breite der Außenmaskierung von ca. 0,25 mm erreichbar ist.

Weitere Ausführungsmöglichkeiten und Merkmale der Maske sowie ein Verfahren zum Abdecken des radial äußeren Bereichs einer scheibenförmigen Substratoberfläche mit Hilfe einer Maske unter Verwendung einer Biegevorrichtung zur Anbringung der Maske am bzw. zum Trennen der Maske vom Substrat sind in weiteren Patentansprüchen näher beschrieben und gekennzeichnet.

Die Erfindung läßt die verschiedensten Ausführungsmöglichkeiten zu; eine davon ist in den anhängenden Zeichnungen beispielhaft dargestellt, und zwar zeigen:
- Fig.1: ein Substrat mit einem zentrischen Substrathalter und der erfindungsgemäßen Maske in Schnittdarstellung,
- Fig.2: die Maske entsprechend Detail X in Fig. 1 in vergrößerter Darstellung,
- Fig.3: den Substrathalter, das Substrat und die Maske in der Draufsicht in verkleinerter Darstellung sowie
- Fig.4: das Substrat gemäß Fig. 1 mit Biegevorrichtung zur Montage der Maske in Schnittdarstellung,
- Fig. 5: zwei Masken Rücken an Rücken in Schnittdarstellung und
- Fig. 6: eine Maske in Rechteckform mit drei zu beschichtenden Substraten in der Draufsicht.

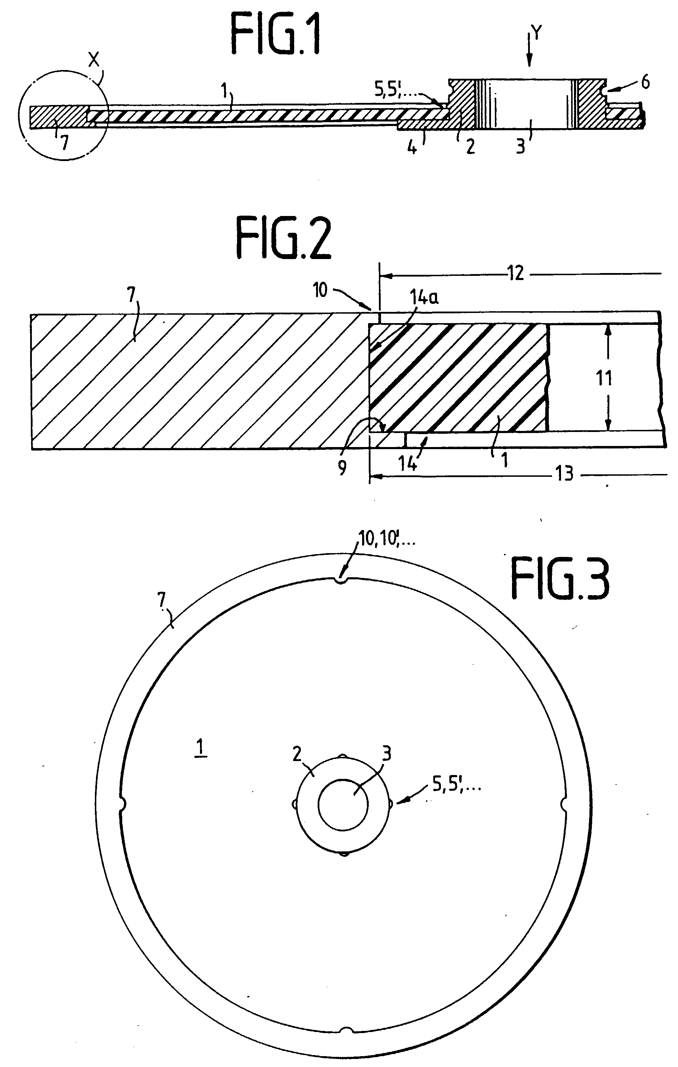

Ein zu beschichtendes, ebenes scheibenförmiges Substrat 1 (Fig.1) weist eine zentrische Bohrung auf, in die ein hohlylindrischer Substrathalter 2 eingesetzt ist. Dieser ist mit einer Axialbohrung 3, sowie an der unteren Stirnseite mit einer ringförmigen Auflage 4 versehen. Das Substrat 1 wird über die Noppen 5, 5',... in axialer Richtung auf den Substrathalter 2 aufgeschoben, bis es an der Auflage 4 aufliegt. An dem Substrathalter 2 ist weiterhin eine ringförmige Nut 6 vorgesehen, in die ein nicht dargestelltes Handling-System zum Halten und Transportieren eingreift.

Das Substrat 1 wird von einer ringförmigen Maske 7 mit einer kreisförmigen Aussparung 14 umgriffen, welche in ihrer Schnittdarstellung ein in etwa rechteckförmiges Profil aufweist. Die gesamte Anordnung Substrat 1, Substrathalter 2 sowie die Maske 7 befinden sich in einer Vakuumkammer 8, die der Einfachheit halber nicht dargestellt ist. Die in Fig. 1 dargestellte Ausführungsform zeigt sowohl eine ringförmige Innen- als auch Außenmaskierung, welche durch die Auflage 4 und eine spezielle Ausformung der Vorderseite der Maske 7 erreicht wird.

Eine vergrößerte Darstellung des Details X in Fig. 1 ist in Fig. 2 gezeigt. Das zu beschichtende Substrat 1 ist konzentrisch von der Maske 7 umgeben. Dabei liegt die Innenwand 14a der Maske 7 nahezu ohne radiales Spiel an der äußeren Umfangsfläche des Substrats 1 an. An ihrer Unterseite ist die Maske 7 mit einer umlaufenden Kreisringfläche 9 versehen, auf die das Substrat 1 aufgelegt ist und die die eigentliche Maskierungsfunktion übernimmt.

Zur exakten Positionierung des Substrats 1 in der Maske 7 ist diese an ihrer oberen Stirnseite mit mehreren, am Umfang gleichmäßig verteilten Noppen 10, 10',... versehen. Der Abstand 11 zwischen der Auflage der Ringfläche 9 und dem Noppen 10 entspricht der Substratdicke. Der diametrale Abstand 12 zwischen den radial innenliegenden Kanten der Noppen 10, 10',... ist geringfügig kleiner gewählt als der Substratdurchmesser 13.

Die Ansicht Y aus Fig. 1 (Fig.3) zeigt zum einen die Kreisringform der Maske 7, sowie die Lage der Arretierungen 5, 5',... und der Noppen 10, 10',... .

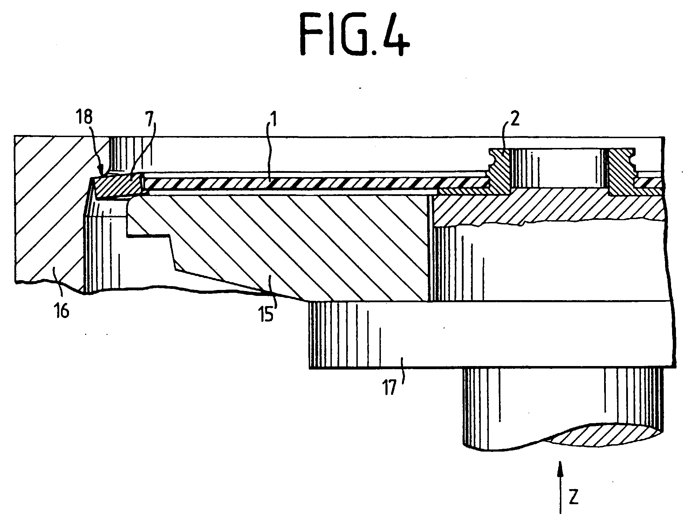

Zur Montage des Substrats 1 in die Maske 7 wird eine Biegevorrichtung 14 verwendet (Fig. 4). Diese besteht im wesentlichen aus einem zentrischen Druckstück 15 sowie einem ringförmigen Gegenlager 16.
Die Maske 7 wird zunächst auf das Druckstück 15 aufgelegt, welches mit Hilfe des Hubelements 17 in axialer Richtung Z bewegt wird, bis die Maske 7 gegen einen Anschlag 18 des ortsfesten Gegenlagers 16 stößt. Sobald die Maske 7 an dem Anschlag 18 anliegt, wird das Druckstück 15 noch so lange in Bewegungsrichtung Z angehoben, bis der diametrale Abstand 12 (Fig. 2) gerade größer ist als der Substratdurchmesser 13. Nun kann das mit dem Substrathalter 2 vormontierte Substrat entgegen der Bewegungsrichtung Z in die Maske 7 eingesetzt werden. Anschließend wird das Druckstück 15 abgesenkt und die Maske 7 klemmt das Substrat 1 an ihrer äußeren Umfangsfläche.

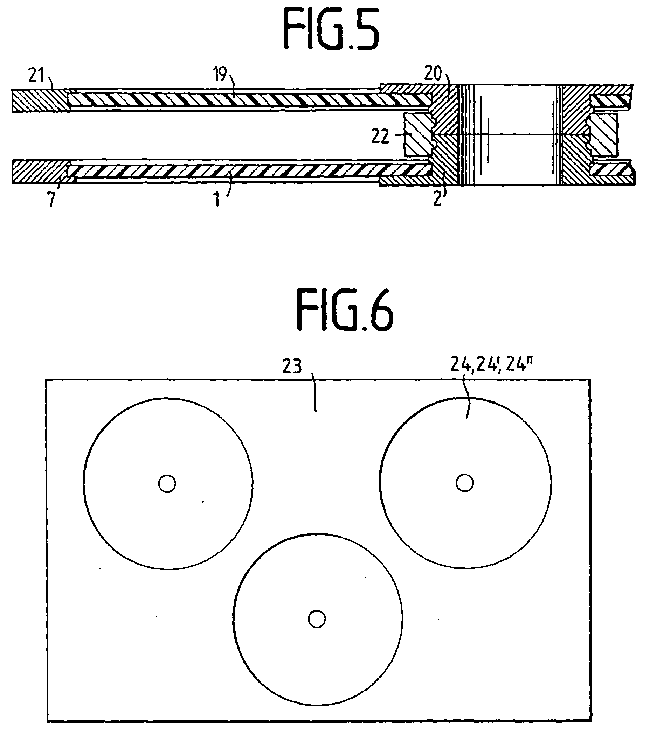

Eine besondere Anordnung von zwei einseitig zu beschichtenden Substraten 1, 19 ist in Fig. 5 dargestellt. Hierzu wird auf die Rückseite der erfindungsgemäßen Ausführung gemäß Fig. 1 eine identische Anordnung, bestehend aus Substrat 19, Substrathalter 20 und einer Maske 21 spiegelsymmetrisch aufgelegt. Die beiden Substrathalter 2, 20 sind durch einen Verbindungsring 22 fixiert. Durch diese Rücken an Rücken Anordnung der Substrate 1 und 19 wird eine Beschichtung der beiden Substratvorderflächen in einem Arbeitsgang ermöglicht.

Eine alternative Ausführungsform einer Maske zeigt Fig. 6. Die Maske 23 ist in Rechteckform ausgebildet und mit drei kreisförmigen Aussparungen zur Aufnahme der Substrate 24, 24', 24'' versehen.

### Bezugszeichenliste

- 1: Substrat
- 2: Substrathalter
- 3: Bohrung
- 4: Auflage - Fläche
- 5, 5',...: Noppe, Zunge
- 6: Nut
- 7: Maske
- 8: Vakuumkammer
- 9: Ringfläche
- 10, 10', ...: Noppe, Zunge
- 11: Abstand, Substratdicke
- 12: Abstand
- 13: Substratdurchmesser
- 14: Aussparung
- 14a: Innenwand
- 15: Druckstück
- 16: Gegenlager
- 17: Hubelement
- 18: Anschlag
- 19: Substrat
- 20: Substrathalter
- 21: Maske
- 22: Verbindungsring
- 23: Maske
- 24, 24', 24'': Substrat
- 25: Substrathalter
- 26: Substrat
- X: Detail
- Y: Ansicht
- Z: Bewegungsrichtung

## Patentansprüche

1. Maske (7) zum Abdecken des radial äußeren Bereichs einer Außenfläche eines scheibenförmigen Substrats (1) während eines Beschichtungsverfahrens, beispielsweise einem Sputter- oder Aufdampfverfahren im Vakuum, **dadurch gekennzeichnet,** daß die Maske (7) aus einem elastischen Werkstoff hergestellt und als ebene Platte mit mindestens einer kreisförmigen Aussparung (14) ausgebildet ist, wobei zur Zentrierung und Arretierung der Maske (7) am Substrat (1) das Substrat mit seiner radialen Umfangsfläche an dem von der Aussparung (14) gebildeten Wandteil (14a) der Maske (7) dicht anliegt, wobei an diesem Wandteil (14a) eine konzentrische, sich radial nach innen zu in einer Ebene parallel zur Substratebene erstreckende, kreisförmige Fläche (9) vorgesehen ist, auf die das Substrat (1) mit seiner einen zu beschichtenden Seitenfläche auflegbar ist, wobei an dem von der Aussparung (14) gebildeten Wandteil (14a) der Maske (7) in einem konstanten Abstand (11) zur Fläche (9) sich radial nach innen zu erstreckende Zungen oder Noppen (10, 10', ...) angeordnet sind, die an der anderen Seitenfläche des Substrats (1) anliegen.

2. Maske nach Anspruch 1, **dadurch gekennzeichnet**, daß die Maske (7) aus Kunststoff oder Metall hergestellt ist.

3. Maske nach Anspruch 1, **dadurch gekennzeichnet**, daß die kreisförmige Aussparung (14) als Durchbruch ausgebildet ist.

4. Maske nach Anspruch 1, **dadurch gekennzeichnet,** daß der Abstand zwischen den Ebenen der Fläche (9) und den Zungen oder Noppen (10, 10',...) der Substratdicke entspricht

5. Maske nach Anspruch 1, **dadurch gekennzeichnet**, daß die Zungen oder Noppen (10, 10',...) gleichmäßig auf den Umfang der kreisförmigen Öffnung (14) verteilt angeordnet sind.

6. Maske nach Anspruch 5, **dadurch gekennzeichnet,** daß der diametrale Abstand (12) zwischen den radial innenliegenden Kanten der Zungen oder Noppen (10, 10',...)im ebenen Zustand der Maske (7) kleiner ist als der Substratdurchmesser (13).

7. Maskenvorrichtung, **dadurch gekennzeichnet,** daß sie aus zwei Masken (7, 21) gemäß dem Anspruch 1 besteht, die Rücken an Rücken montiert sind.

8. Maske nach Anspruch 1, **dadurch gekennzeichnet,** daß die Maske (23) zwei oder mehr kreisförmige Aussparungen (14) zur Aufnahme der Substrate (24, 24', 24'') aufweist.

9. System umfassend eine Maske nach Anspruch 1 und ein Substrat, **dadurch gekennzeichnet,** daß die Maske (7) am Substrat (1) arretiert ist und beide Teile zusammen durch eine Vakuumkammer (8) hindurch bewegbar sind.

10. Verfahren zum Abdecken des radial äußeren Bereichs einer scheibenförmigen Substratoberfläche während eines Beschichtungsverfahrens im Wege des Aufdampfens oder Aufsputterns in einer Prozeßkammer mit Hilfe einer Maske, **dadurch gekennzeichnet,** daß die Maske (7) gemäß den Ansprüchen 1 bis 8 mit einem ortsfesten Anschlag (18) eines ringförmigen Gegenlagers (16) einer Biegevorrichtung zusammenwirkt, wobei die auf dem Substrat (1) arretierte Maske (7) eine Stülpbewegung aus der Substratebene heraus vollzieht, wozu die Maske (7) von einem Druckstück (15) der Biegevorrichtung gegen den Anschlag (18) des Gegenlagers (16) bewegbar ist, wobei das Druckstück (15) an der Unterseite an der radial innen liegenden Kante der Maske (7) angreift, während gleichzeitig der ortsfeste Anschlag (18) der Biegevorrichtung an der radial außen liegenden oberen Kante der Maske (7) anliegen muß.

11. Verfahren nach Anspruch 10, **dadurch gekennzeichnet,** daß der Anschlag (18) des ringförmigen Gegenlagers (16) und das bewegbare Druckstück (15) der Biegevorrichtung konzentrisch zueinander angeordnet sind.

12. Verfahren nach Anspruch 10, **dadurch gekennzeichnet,** daß der Innendurchmesser des ortsfesten Anschlags (18) des Gegenlagers (16) größer bemessen ist als der Außendurchmesser des bewegbaren Druckstücks (15).

13. Verfahren nach Anspruch 10, **dadurch gekennzeichnet,** daß die Maske (7) auf das Druckstück (15) aufgelegt und mit dem Druckstück (15) so weit gegen den Anschlag (18) bewegt wird, bis der diametrale Abstand (12) zwischen den Zungen oder Noppen (10, 10',...) größer als der Substratdurchmesser (13)ist.

## Claims

1. Mask (7) for covering the radially outer region of an outer surface of a disc-like substrate (1) during a coating process, for example a sputtering or vacuum metallising process, characterised in that the mask (7) is manufactured from a resilient material and is formed as a plane plate with at least one circular recess (14), wherein for centring and locking of the mask (7) on the substrate (1) the substrate abuts in a sealing-tight manner with its radial circumferential face the wall part (14a) of the mask (7) formed by the recess (14), wherein on this wall part (14a) a concentric, circular face (9) is provided which extends radially inward in a plane parallel to the substrate plane and on to which the substrate (1) can be placed with one of its lateral faces to be coated, wherein on the wall part (14a) of the mask (7) formed by the recess (14), at a constant distance (11) from the face (9), radially inwardly extending tongues or projections (10, 10', ...) are formed, which abut the other lateral face of the substrate (1).

2. Mask according to claim 1, characterised in that the mask (7) is manufactured from plastics material or metal.

3. Mask according to claim 1, characterised in that the circular recess (14) is formed as a hole.

4. Mask according to claim 1, characterised in that the distance between the planes of the face (9) and the tongues or projections (10, 10', ...) corresponds to the substrate thickness.

5. Mask according to claim 1, characterised in that the tongues or projections (10, 10', ...) are distributed evenly around the circumference of the circular aperture (14).

6. Mask according to claim 5, characterised in that the diametral distance (12) between the radially inner edges of the tongues or projections (10, 10', ...) in the plane state of the mask (7) is smaller than the substrate diameter (13).

7. Mask device, characterised in that it consists of two masks (7, 21) according to claim 1, which are assembled back to back.

8. Mask according to claim 1, characterised in that the mask (23) has two or more circular recesses (14) for receiving the substrates (24, 24', 24'').

9. System comprising a mask according to claim 1 and a substrate, characterised in that the mask (7) is locked to the substrate (1) and both parts together are movable through a vacuum chamber (8).

10. Method of covering the radially outer region of a disc-shaped substrate surface during a coating process in the course of vapour deposition or sputtering in a processing chamber by means of a mask, characterised in that the mask (7) according to claims 1 to 9 cooperates with a fixed stop (18) of an annular abutment (16) of a bending device, wherein the mask (7) locked on to the substrate (1) completes a tilting movement out of the substrate plane, to which end the mask (7) is movable by a pressure member (15) of the bending device against the stop (18) of the abutment (16), and the pressure member (15) acts on the under-side of the radially inner edge of the mask (7), whilst simultaneously the fixed stop (18) of the bending device must abut the radially outer, upper edge of the mask (7).

11. Method according to claim 10, characterised in that the stop (18) of the annular abutment (16) and the movable pressure member (15) of the bending device are disposed concentrically to one another.

12. Method according to claim 10, characterised in that the inner diameter of the fixed stop (18) of the abutment (16) is larger than the outer diameter of the movable pressure member (15).

13. Method according to claim 10, characterised in that the mask (7) is placed on the pressure member (15) and is moved with the pressure member (15) so far towards the stop (18) that the diametral distance (12) between the tonges or projections (10, 10', ...) is greater than the substrate diameter (13).

## Revendications

1. Masque (7) pour recouvrir la région radiale extérieure d'une surface extérieure d'un substrat (1) en forme de disque pendant un procédé de revêtement, par exemple un procédé de pulvérisation cathodique ou de métallisation sous vide, caractérisé en ce que le masque (7) est fabriqué en une matière plastique et réalisé sous la forme d'une plaque plane comportant au moins un évidement (14) circulaire, le substrat reposant de façon intime avec sa surface périphérique sur la partie de paroi (14a) formée par l'évidement (14) pour centrer et arrêter le masque (7) sur le substrat (1), une surface (9) circulaire s'étendant radialement vers l'intérieur dans un plan parallèle au plan du substrat étant prévue sur cette partie de paroi (14a), le substrat (1) étant susceptible d'être posé sur ladite surface avec l'une de ses faces à enduire, des languettes ou des pastilles (10, 10', ...) s'étendant radialement vers l'intérieur étant agencées sur la partie de paroi (14a) du masque (7) qui est formée par l'évidement (14) à une distance (11) constante par rapport à la surface (9), lesdites languettes reposant sur l'autre surface du substrat (1).

2. Masque selon la revendication 1, caractérisé en ce que le masque (7) est réalisé en matière plastique ou en métal.

3. Masque selon la revendication 1, caractérisé en ce que l'évidement circulaire (14) est réalisé sous la forme d'une traversée.

4. Masque selon la revendication 1, caractérisé en ce que la distance entre les plans de la surface (9) et les languettes ou pastilles (10, 10', ...) correspondent à l'épaisseur du substrat.

5. Masque selon la revendication 1, caractérisé en ce que les languettes ou pastilles (10, 10', ...) sont réparties de façon régulière sur la périphérie de l'ouverture (14) circulaire.

6. Masque selon la revendication 5, caractérisé en ce que la distance diamétrale (12) entre les arêtes radiales intérieures des languettes ou pastilles (10, 10', ...) est inférieure au diamètre du substrat (13) à l'état plat du masque (7).

7. Dispositif de masque, caractérisé en ce qu'il est constitué par deux masques (7, 21) selon la revendication 1, qui sont montés dos à dos.

8. Masque selon la revendication 1, caractérisé en ce que le masque (23) présente deux ou plusieurs évidements (14) circulaires destinés à recevoir les substrats (24, 24', 24").

9. Système comprenant un masque selon la revendication 1 et un substrat, caractérisé en ce que le masque (7) est arrêté sur le substrat (1) et en ce que les deux pièces sont susceptibles d'être déplacées ensemble à travers une chambre de vide (8).

10. Procédé de recouvrement de la région radiale extérieure d'une surface de substrat en forme de disque pendant un procédé de revêtement par la voie de la métallisation sous vide ou de la pulvérisation cathodique dans une chambre de traitement à l'aide d'un masque, caractérisé en ce que le masque (7) selon les revendications 1 à 9 coopère avec une butée (18) stationnaire d'un contre-appui annulaire (16) d'un dispositif de flexion, le masque (7) arrêté sur le substrat (1) effectuant un mouvement de retournement depuis le plan du substrat, ce pourquoi le masque (7) est susceptible d'être déplacé par un organe de pressage (15) du dispositif de flexion contre la butée (18) du contre-appui (16), l'organe de pressage (15) attaquant la face inférieure au niveau de l'arête radiale intérieure du masque (7) tandis qu'en même temps, la butée stationnaire (18) du dispositif de flexion doit reposer sur l'arête supérieure radiale extérieure du masque (7).

11. Procédé selon la revendication 10, caractérisé en ce que la butée (18) du contre-appui (16) annulaire et l'organe de pressage (15) déplaçable du dispositif de flexion sont agencés de manière concentrique l'un par rapport à l'autre.

12. Procédé selon la revendication 10, caractérisé en ce que le diamètre intérieur de la butée (18) stationnaire du contre-appui (16) est supérieur au diamètre extérieur de l'organe de pressage (15) déplaçable.

13. Procédé selon la revendication 10, caractérisé en ce que le masque (7) est placé sur l'organe de pressage (15) et déplacé avec l'organe de pressage (15) aussi loin contre la butée (18) jusqu'à ce que la distance (12) diamétrale entre les languettes ou pastilles (10, 10', ...) soit plus grande que le diamètre du substrat (13).
